(19) Europäisches Patentamt
European Patent Office
Office européen des brevets

(11) **EP 4 362 051 A1**

(12) **EUROPEAN PATENT APPLICATION**

(43) Date of publication:
**01.05.2024 Bulletin 2024/18**

(21) Application number: **23204030.3**

(22) Date of filing: **17.10.2023**

(51) International Patent Classification (IPC):
**H01F 41/00** (2006.01)    **H01F 27/28** (2006.01)
**H01F 27/02** (2006.01)    **H01F 27/38** (2006.01)

(52) Cooperative Patent Classification (CPC):
**H01F 41/005; H01F 27/022; H01F 27/38;**
H01F 2027/2809

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **25.10.2022 US 202218049491**

(71) Applicant: **Delta Electronics, Inc.
Neihu, Taipei 11491 (TW)**

(72) Inventors:
• **ANURAG, Anup
Durham, NC, 27709 (US)**

• **ZHANG, Chi
Durham, NC, 27709 (US)**
• **WANG, Ruxi
Durham, NC, 27709 (US)**
• **SHEN, Zhiyu
Durham, NC, 27709 (US)**
• **BARBOSA, Peter Mantovanelli
Durham, NC, 27709 (US)**

(74) Representative: **Uexküll & Stolberg
Partnerschaft von
Patent- und Rechtsanwälten mbB
Beselerstraße 4
22607 Hamburg (DE)**

(54) **PRINTED CIRCUIT BOARD, POWER TRANSFORMER, AND MANUFACTURING METHOD THEREOF**

(57) The present disclosure provides a power transformer (1000) for medium voltage semiconductor devices. In one aspect, the power transformer (1000) includes a primary winding (1010) and a secondary winding (1020), a primary magnetic core (1040A) wound by the primary winding (1010), a secondary magnetic core (1040B) wound by the secondary winding (1020), and a coupling coil (1030) wound about the primary and secondary magnetic cores (1040A, 1040B).

FIG. 10

**Description**

FIELD OF THE INVENTION

The present disclosure relates to a printed circuit board (PCB) for a power supply. More specifically, the present disclosure relates to a power transformer for the power supply and a manufacturing method thereof.

BACKGROUND OF THE INVENTION

The advancement of wide bandgap semiconductor devices such as Silicon Carbide metal-oxide-field-effect transistors (SiC MOSFETs), Silicon Carbide insulated-gate-bipolar-transistors (SiC IGBTs) and Gallium Nitride Field Effect Transistors (GaN FETs) requires certain advanced design considerations from the perspective of driving the power semiconductor devices. Nowadays, power semiconductor devices are available for blocking voltages of more than 15 kV and an isolated power supply for the gate driver is required for driving these devices. Due to the high switching speed (dv/dt) and the high voltage isolation requirement for the medium voltage devices, it is necessary to have an isolated power supply for the gate driver which can handle the high voltage while having a low parasitic capacitance across the isolation barrier.

For the isolated power supply, the isolation is typically obtained by a conventional transformer using a magnetic core. This solution has been widely used in the industry as well as the academia for both silicon and silicon carbide devices, especially when the blocking voltage of each device is less than 3.3 kV This solution is also used for silicon devices with higher blocking voltage (~6.5 kV). However, for medium voltage SiC power devices, owing to its fast-switching transients, special considerations are taken while designing this isolated power supply. Along with the high isolation capability of the isolated power supply, a small parasitic capacitance is imperative for driving fast switching SiC devices.

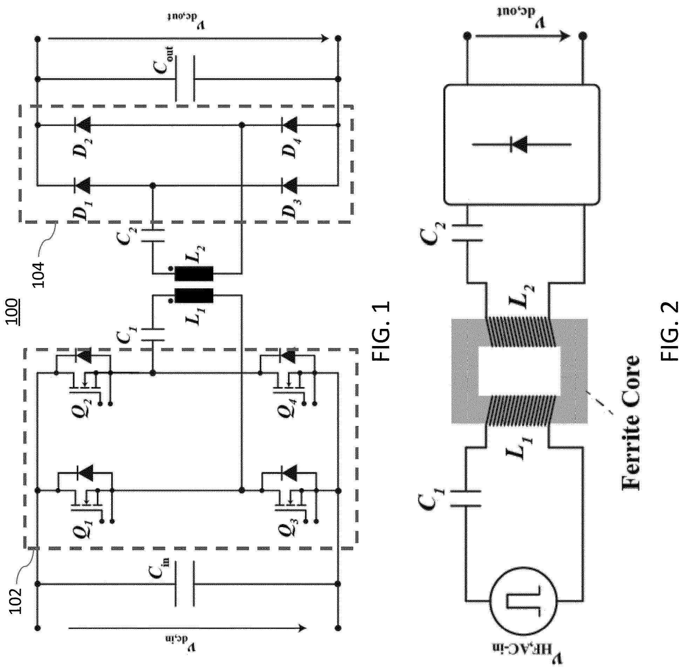

FIG. 1 shows a conventional isolated power supply with a series-series resonant converter. However, both resonant and non-resonant topologies can be used to form the primary side of the isolated power supply. Similarly, the diodes in the secondary side can also be replaced by active devices under certain conditions. Using this structure for driving medium voltage SiC devices requires certain changes in the structure of the conventional transformer core, to account for the high voltage blocking capacity and the requirement of low parasitic capacitance.

The following references disclose conventional transformer structures that provide the required MV (medium voltage) isolation for the gate drivers, and have been demonstrated for MV SiC power devices. Nevertheless, while the techniques disclosed in the references can achieve a high isolation along with a reduction in parasitic capacitance, they result in a high device volume and thus are difficult to manufacture.

[Ref. 1] A. Kadavelugu and S. Bhattacharya, "Design considerations and development of gate driver for 15 kV SiC IGBT," 2014 IEEE Applied Power Electronics Conference and Exposition - APEC 2014, 2014, pp. 1494-1501, doi: 10.1109/APEC.2014.6803505 ("Kadavelugu").

[Ref. 2] A. Anurag, S. Acharya, Y. Prabowo, G. Gohil and S. Bhattacharya, "Design Considerations and Development of an Innovative Gate Driver for Medium-Voltage Power Devices With High dv/dt," in IEEE Transactions on Power Electronics, vol. 34, no. 6, pp. 5256-5267, June 2019, doi: 10.1109/TPEL.2018.2870084 ("Anurag").

[Ref. 3] L. Zhang et al., "Design Considerations for High-Voltage Insulated Gate Drive Power Supply for 10-kV SiC MOSFET Applied in Medium-Voltage Converter," in IEEE Transactions on Industrial Electronics, vol. 68, no. 7, pp. 5712-5724, July 2021, doi: 10.1109/TIE.2020.3000131 ("Zhang").

In Kadavelugu's design, a toroidal magnetic core is used with copper wires wound across the same with Kapton tape in between to achieve the required insulation. This, however, gives a high parasitic capacitance and the Kapton tape does not provide a reliable insulation for the MV isolation. In Anurag's solution and Zhang's solution, the copper wire used in Kadavelugu's solution was replaced with PCB (printed circuit board) winding and the toroidal shaped core is changed to two connected C-cores. Zhang enclosed the whole power supply in a potting material. This increases the reliability of the isolated power supply, but due to the presence of two C-cores leads to difficulty in manufacturing.

Another solution is proposed in an article titled "Highly Compact Isolated Gate Driver With Ultrafast Overcurrent Protection for 10 kV SiC MOSFETs" by Rothmund et al., published in CPSS Transactions on Power Electronics and Applications, vol. 3, no. 4, pp. 278-291, Dec. 2018 ("Rothmund") [Ref. 4]. Rothmund achieves the required MV isolation of the transformer by separating the cores and placing an air gap between them. The winding is realized using litz wire and the entire isolated power supply was enclosed in a potting material.

An article titled "Current-Transformer Based Gate-Drive Power Supply with Reinforced Isolation", by Hu et al. published in 2018 IEEE Energy Conversion Congress and Exposition (ECCE), 2018 [Ref. 5], takes a different approach and uses a current transformer based gate driver power supply. The required MV isolation is achieved by using a MV insulated wire on the primary side of the isolated power supply. A similar approach is also reported in "A galvanically isolated gate driver with low coupling capacitance for medium voltage SiC MOSFETs" by Gottschlich et al. in 2016 18th European Conference on Power Electronics and Applications (EPE'16 ECCE Europe).

In another article titled "Design of Gate Drive Power Supply with Air Core Transformer for High dv/dt Switching", by Mainali et al. published in 2018 IEEE Energy Conversion Congress and Exposition (ECCE), 2018 [Ref. 6], the authors have demonstrated the operation of an air core transformer with low coupling capacitance. The design does not contain any magnetic material and uses an interlink coil to increase the coupling between the primary and secondary side winding. This concept is also patented in a patent titled "Gate Driver" (Wang R. et al., "Gate Driver", US Patent No. 10,809,326 B2, issued Oct. 20, 2020).

While the existing methods are capable of achieving the required MV isolation along with having a low parasitic capacitance, there is a need to provide a more comprehensive solution which provides good performance and can be manufactured easily.

SUMMARY OF THE INVENTION

In one aspect, the present disclosure provides a power transformer including: a primary winding and a secondary winding; a primary magnetic core wound by the primary winding; a secondary magnetic core wound by the secondary winding; and an electrically conductive coupling coil wound about the primary and secondary magnetic cores.

In one embodiment, the primary winding includes a first top coil and a first bottom coil electrically connected to the first top coil, and wherein the secondary winding includes a second top coil and a bottom coil electrically connected to the second top coil.

In one embodiment, the coupling coil is a closed loop disposed between the first and second top coils and the first and second bottom coils.

In one embodiment, the power transformer further includes a printed circuit board (PCB) having a first hole and a second hole, wherein the first and second top coils are disposed on a top surface of the PCB, wherein the first and second bottom coils are disposed on a bottom surface of the PCB, and wherein the coupling coil is embedded in a central layer of the PCB.

In one embodiment, the primary magnetic core is inserted in the first hole and the secondary magnetic core is inserted in the second hole.

In one embodiment, the power transformer further includes a printed circuit board (PCB) having a first hole and a second hole, wherein the primary and secondary windings are embedded in a central layer of the PCB, and wherein the coupling coil is disposed on a surface of the PCB.

In one embodiment, the coupling coil includes a first closed loop and a second closed loop.

In one embodiment, the primary and secondary windings are disposed between the first and second closed loops.

In one embodiment, the power transformer further includes a printed circuit board (PCB) having a first hole and a second hole, wherein the primary and secondary windings are embedded in a central layer of the PCB, wherein the first closed loop is disposed on a top surface of the PCB, and wherein the second closed loop is disposed on a bottom surface of the PCB.

In one embodiment, the primary magnetic core is inserted in the first hole and the secondary magnetic core is inserted in the second hole.

In another aspect, the present disclosure provides a printed circuit board (PCB), including: a primary winding wound about a first hole of the PCB; a secondary winding wound about a second hole of the PCB; and a coupling coil forming a closed loop surrounding the first and second holes of the PCB.

In one embodiment, the coupling coil is embedded in a central layer of the PCB.

In one embodiment, the coupling coil includes a plurality of conductive loops that are electrically insulated from each other.

In one embodiment, the primary winding includes a top layer on a top surface of the PCB and a bottom layer on a bottom surface of the PCB, the top and bottom layers of the primary winding being electrically connected.

In one embodiment, the secondary winding includes a top layer on a top surface of the PCB and a bottom layer on a bottom surface of the PCB, the top and bottom layers of the secondary winding being electrically connected.

In one embodiment, the primary and secondary windings are embedded in a central layer of the PCB.

In one embodiment, the coupling coil is disposed on a top surface of the PCB

In one embodiment, the coupling coil includes a first coupling coil and a second coupling coil, wherein the first coupling coil is disposed on a top surface of the PCB and the second coupling coil is disposed on a bottom surface of the PCB.

In one embodiment, the PCB further includes primary terminals to receive an input voltage applied to the primary winding.

In one embodiment, the PCB further includes secondary terminals to provide an output voltage induced by the secondary winding.

In another aspect, the present disclosure provides a method for manufacturing a transformer, including: providing a container having an opening; inserting a plurality of PCB-based windings in the container through the opening, each of the plurality of PCB-based windings having one or more terminals, such that all the terminals of the plurality of PCB-based windings are arranged at a same side of the container; and encapsulating the transformer by filling an encapsulant in the container through the opening, with each of the terminals of the plurality of PCB-based windings being connected to an electric wire leading exterior to the encapsulant.

In one embodiment, the method for manufacturing a transformer further includes: prior to inserting the plurality of PCB-based windings in the container, inserting a magnetic core through a central through hole of each of the plurality of PCB-based windings.

BRIEF DESCRIPTION OF THE DRAWINGS

FIG. 1 illustrates a schematic diagram of a series-series resonant converter as an isolated power supply for a gate driver.

FIG. 2 illustrates a schematic diagram of a conventional isolated power supply based on a transformer.

FIG. 3 illustrates a schematic diagram of a conventional isolated power supply based on a transformer with air gap and insulation.

FIG. 4 illustrates a schematic diagram of a power supply based on air core with an interlink coil.

FIG. 5 illustrates a schematic diagram of an isolated power supply including coupling coils and ferrite cores to improve the coupling between primary and secondary winding, in accordance with an embodiment of the present disclosure.

FIG. 6 illustrates the schematic diagram of the circuit model for a series-series resonant converter, with a small coupling coefficient, in accordance with an embodiment of the present disclosure.

FIG. 7 illustrates a graphical representation of the gain curve of the series-series resonant converter of FIG. 6, and the choice for the operating frequency of the converter to achieve a load independent operation.

FIG. 8 illustrates a schematic diagram of a rectifier having a diode bridge.

FIG. 9 illustrates a schematic diagram of a rectifier having a voltage doubler.

FIG. 10 illustrates an isolated gate driver transformer for a gate driver, in accordance with an embodiment of the present disclosure.

FIGs. 11A and 11B are sectional views of a PCB-based transformer of FIG. 10, demonstrating the placement of the coupling coil with respect to the primary and secondary windings.

FIG. 12 illustrates an isolated gate driver transformer for a gate driver having increased coupling between primary and secondary windings, in accordance with another embodiment of the present disclosure.

FIGs. 13A and 13B are sectional views of a PCB-based transformer of FIG. 12, demonstrating the placement of the coupling coil with respect to the primary and secondary windings.

FIG. 14 illustrates a schematic diagram of a coupled transformer with primary and secondary windings and a coupling coil using copper wires and plastic (or any non-conductive material) bobbins housing magnetic cores (made of, e.g., ferrite), in accordance with a further embodiment of the present disclosure.

FIGs. 15A and 15B illustrate a variation of the coupled transformer of FIG. 14, with the windings and the coupling coil wound about a single magnetic core structure.

FIGs. 16A and 16B illustrate a variation of the coupled transformer of FIG. 14, with the windings wound about a single magnetic core structure, without the coupling coil.

FIGs. 17A and 17B illustrate another variation of the coupled transformer of FIG. 14, with a primary winding and multiple secondary windings wound about a single magnetic core structure, without the coupling coil.

FIG. 18 illustrates a container for housing a PCB-based transformer, in accordance with an embodiment of the present disclosure.

FIG. 19 illustrates a container in which a PCB-based transformer is housed, in accordance with an embodiment of the present disclosure.

DETAILED DESCRIPTION OF THE PREFERRED EMBODIMENT

The present disclosure will now be described more specifically with reference to the accompanying drawings. It is to be noted that the following detailed descriptions are presented herein for purpose of illustration and description only. It is not intended to be exhaustive or to be limited to the precise form disclosed.

One embodiment of the present disclosure is aimed at an isolated power supply for a gate driver using a coupled transformer capable of being reliably utilized in medium voltage converter systems. The isolated power supply includes a coupled transformer and a resonant converter. The coupled transformer is coupled using two magnetic cores and coupling coils. In the embodiment, the structure helps in achieving a low parasitic capacitance between the primary and secondary windings, while maintaining a high voltage insulation, which is necessary for operating medium voltage converter systems. The low parasitic capacitance between the primary and the secondary winding reduces the effect of the fast-switching transients (dv/dt) of the device.

FIG. 1 shows a schematic diagram of a series-series resonant converter 100 as an isolated power supply for a gate driver. A resonant converter is typically used over non-resonant counterparts to reduce the effect of the leakage inductance on the output voltage regulation of the converter. As shown in FIG. 1, a full-bridge inverter 102 is used to generate a high frequency AC signal from the DC voltage ($v_{dc,in}$). The resonant tank includes capacitors $C_1$ and $C_2$ connected in series with the transformer on both the primary and the secondary side. A diode bridge rectifier 104 is connected on the secondary side to convert the high frequency AC signal to an isolated DC voltage.

FIG. 2 shows a schematic diagram of a conventional isolated power supply based on a transformer. The series-series compensated topology, as well as the diode bridge rectifier is shown in a simplified version in the figure. As seen, a conventional transformer having a complete closed magnetic core is used as the isolation structure for the isolated power supply. Conventionally, these types of transformers are used for providing electrical insulation. The major advantage of using such a structure is that this structure offers a very high magnetizing inductance and low leakage inductance which is preferred in certain applications since the core does not have any air gap and the windings are placed closed to the core. Since these structures offer a low leakage inductance, a non-resonant topology can also be used to drive these transformers. With some variations, the windings may also be made on a PCB based structure. However, this generally increases the leakage inductance of the transformer. In case a medium/high voltage is required between the primary and the secondary side, the insulation needs to be achieved between the windings and the core, which might not always be preferred.

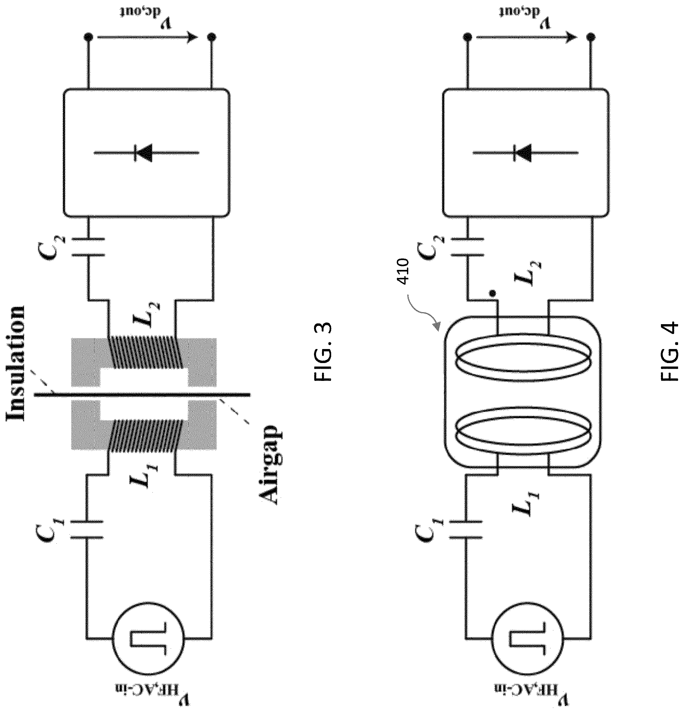

FIG. 3 is a schematic diagram of a conventional isolated power supply based on a transformer with air gap and insulation. The isolated power supply as shown in FIG. 3 is a design variation of that shown in FIG. 2. As shown in FIG. 3, a small air gap is introduced between the cores, and an insulation layer is provided. This structure offers a lower magnetizing inductance as compared to FIG. 2. However, this design proves to be advantageous when a medium/high voltage isolation is required between the primary side and the secondary side winding. The insulation requirement transfers from the winding-to-core to the insulation between the air gap, and it is easier to achieve this insulation.

FIG. 4 is a schematic diagram of a power supply based on air core with an interlink coil. As shown in FIG. 4, an air core transformer is introduced, which includes the primary winding and the secondary winding, without any magnetic coupling between them. The structure does not contain any magnetic material. An interlink wire 410 is used to improve the coupling between the primary and the secondary winding structure.

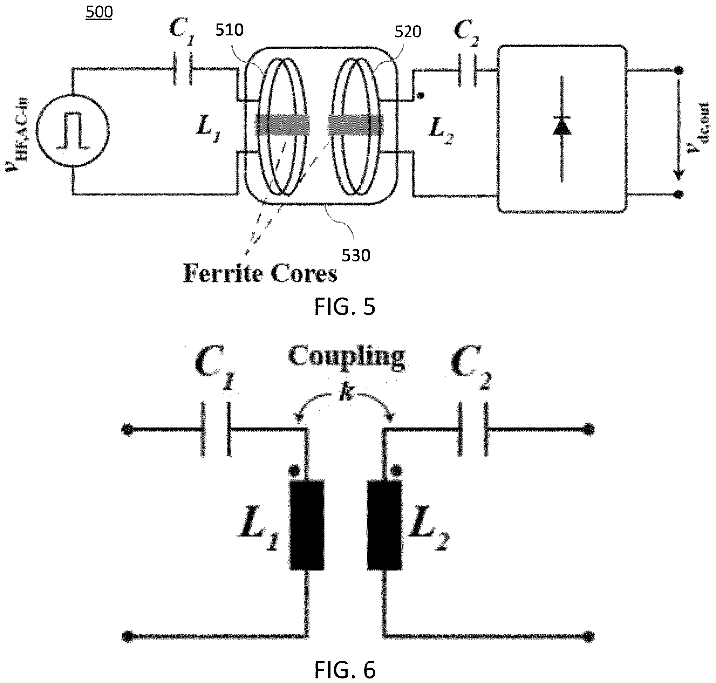

FIG. 5 illustrates a schematic diagram of an isolated power supply 500 including coupling coils and ferrite cores to improve the coupling between primary and secondary windings, in accordance with an embodiment of the present disclosure. As depicted in FIG. 5, each isolated power supply 500 for gate driver includes a primary winding 510 with a magnetic material (e.g., a ferrite core), a secondary winding 520 with a magnetic material (e.g., a ferrite core) and a coupling coil 530, along with additional power electronic converter systems. The presence of the magnetic materials between the individual windings helps in increasing the magnetic coupling between primary and secondary windings 510 and 520. Coupling coil 530 is added to further improve the magnetic coupling between primary and secondary windings 510 and 520. Primary winding 510, secondary winding 520, coupling coil 530, and the magnetic cores are arranged in such a way that it provides an acceptable magnetic coupling, while maintaining a high voltage insulation between primary and secondary windings 510 and 530. This maintains the electric field in the structure to be less than 10 kV/mm. Further, the arrangement is made in such a manner that the capacitance between primary and secondary windings 510 and 520 is low. As shown, the coupled transformer is connected to a power electronics converter which converts DC to high frequency AC. The output side of this coupled transformer is connected to a rectifier which converts the high frequency AC to DC which can be connected to the load.

When the coupled transformer has a low inductive coupling coefficient, as in this embodiment, a resonant converter is necessary to achieve voltage regulation on the output. A series-series resonant converter as shown in FIG. 6 could be used to achieve the required voltage regulation. Here, inductor Li could be realized as the self-inductance of primary winding 510 of the coupled transformer and inductor $L_2$ may be realized as the self-inductance of secondary winding 520 of the coupled transformer. The coupled transformer is assumed to have a coupling factor k, which may be in range of 0.2-0.5 (loosely coupled). Capacitor Ci is connected with primary winding 510 of the coupled transformer and capacitor $C_2$ is connected with secondary winding 520 of the coupled transformer. These capacitors are designed in such a way that it compensates for the low coupling factor of the coupled transformer. The design stems from the fact that the resonant converter is operated at a frequency which gives the best voltage regulation. This is achieved by designing the capacitance and operating frequency according to:

$$C_1 = C_2 = \frac{1}{(2\pi f)^2 L_1(1-k)} \qquad \text{(Equation 1)}$$

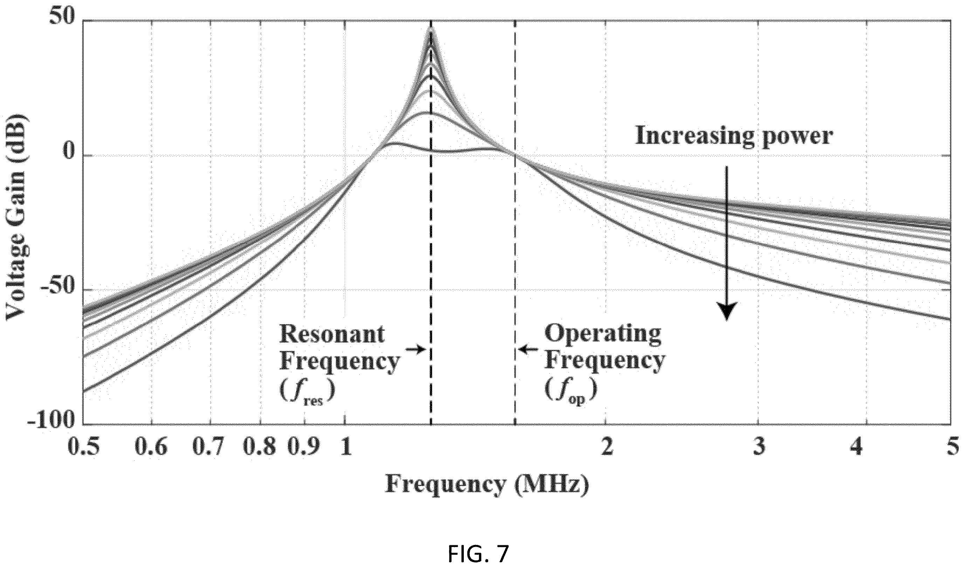

FIG. 7 illustrates a graphical representation of the gain curve of the series-series resonant converter of FIG. 6, and the choice for the operating frequency of the converter to achieve a load independent operation. As shown in FIG. 7, at the operating frequency $f_{op}$, the gain of the converter does not change, which gives a load independent output voltage. Further, because the operation is carried out slightly above the resonant frequency $f_{res}$, the phase angle of the operating point, as seen by the primary side converter, is positive which guarantees soft-switching behavior of the MOSFETs, thus minimizing losses in the converter system. A linear voltage regulator may be connected before the output DC port to compensate for small variations in the voltage due to practical considerations.

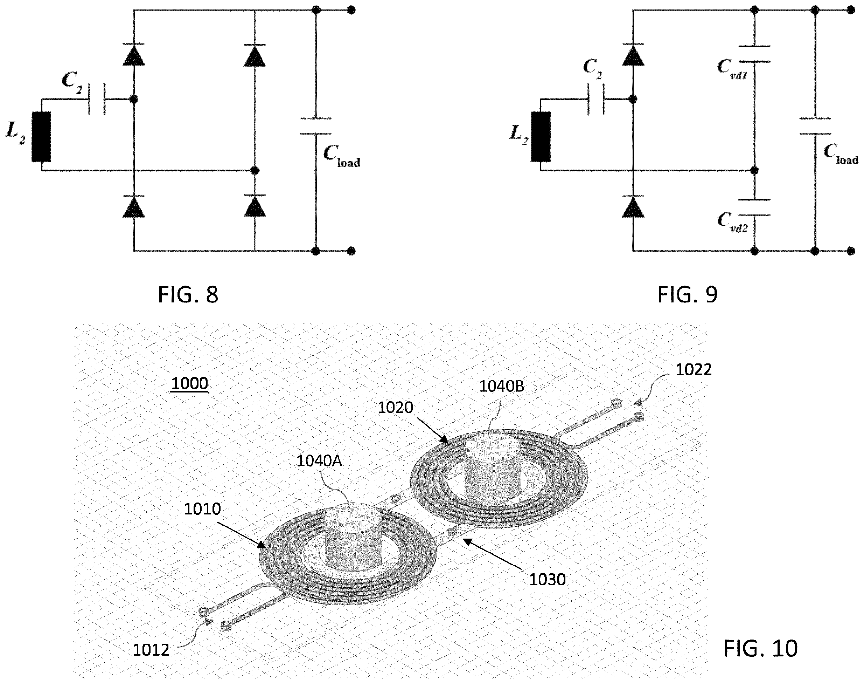

In all isolated power supplies, a rectifier is included to convert the high frequency AC that is seen at the secondary winding of the transformer. FIGs. 8 and 9 show two possible rectifier circuits that may be used in this isolated gate driver system. FIG. 8 illustrates a schematic diagram of a rectifier having a diode bridge. FIG. 9 illustrates a schematic diagram of a rectifier having a voltage doubler. A capacitor is connected at the output of the diode bridge to filter out any ripples in the voltage. The load is connected across the capacitor.

FIG. 10 illustrates an isolated gate driver transformer 1000 for a gate driver, in accordance with an embodiment of the present disclosure. The isolated gate driver transformer 1000 includes two windings, namely, a primary winding 1010 and a secondary winding 1020. Magnetic cores 1040A and 1040B are inserted between individual windings to increase the inductive coupling between them. A coupling coil 1030 is also provided to further increase the inductive coupling between primary and secondary windings 1010 and 1020. The position of coupling coil 1030 determines the inductive coupling. In operation, input voltage can be applied to primary winding 1010 via primary terminals 1012, while, output voltage can be harvested from secondary winding 1020 via secondary terminals 1022.

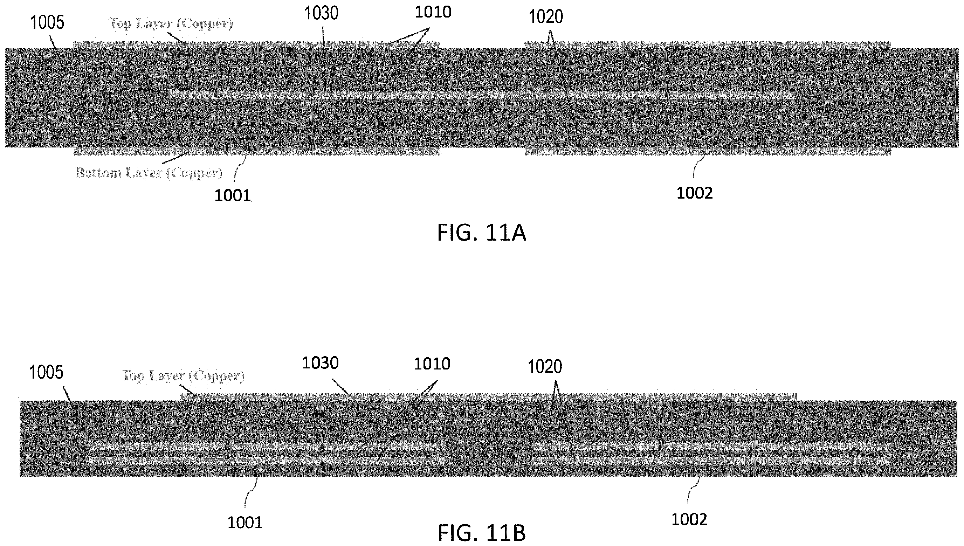

FIGs. 11A and 11B are sectional views of a PCB-based transformer of FIG. 10, demonstrating the placement of the coupling coil with respect to the primary and secondary windings. FIGs. 11A and 11B show two different options for the placement of coupling coil 1030. It should be noted that in the embodiment the placement of coupling coil 1030 needs to be carried out based on the maximum electric field as well as the inductive coupling. Generally, when the coupling coil is placed between individual coils of the primary/secondary windings, as shown in FIG. 11A, a higher coupling is observed, along with a high electric field. Moving the coupling coil to either the top side or the bottom side of the windings, as shown in FIG. 11B, reduces the maximum electric field, but also reduces the coupling.

As shown in FIG. 11A, primary winding 1010 includes a top coil layer (made of copper) on a top surface of PCB 1005, and a bottom coil layer (made of copper) on a bottom surface of PCB 1005. Top and bottom coil layers of primary winding 1010 are electrically connected in series. Likewise, secondary winding 1020 includes a top coil layer (made of copper) on a top surface of PCB 1005, and a bottom coil layer (made of copper) on a bottom surface of PCB 1005. Top and bottom coil layers of secondary winding 1020 are electrically connected in series. Primary winding 1010 is wound about a primary hole 1001 on PCB 1005, and a first magnetic core can be inserted therein. Secondary winding 1020 is wound about a secondary hole 1002 on PCB 1005, and a second magnetic core can be inserted therein. It is appreciated that the first and second magnetic cores may be a single piece or two isolated pieces as shown in FIG. 10. Coupling coil 1030 is embedded in the middle (central layer) of PCB 1005 to form a closed loop that surrounds both primary and secondary holes 1001 and 1002. It is appreciated that multiple loops of coupling coil 1030 could be embedded in PCB 1005 depending on design choices. Coupling coil 1030 may be made of any suitable material (e.g., copper or aluminum) that enhances magnetic coupling between primary and secondary windings 1010 and 1020.

Alternatively, as shown in FIG. 11B, primary winding 1010 includes one or more series-connected coil layers embedded in PCB 1005, and secondary winding 1020 includes one or more series-connected coil layers embedded in PCB 1005. Primary winding 1010 is wound about a primary hole 1001 on PCB 1005, and a first magnetic core can be inserted therein. Secondary winding 1020 is wound about a secondary hole 1002 on PCB 1005, and a second magnetic core may be inserted therein. Coupling coil 1030 may be formed on the top surface of PCB 1005 to form a closed loop that surrounds primary and secondary holes 1001 and 1002. It is appreciated that one or more additional coupling coils can be formed on a bottom surface of PCB 1005 or embedded in PCB 1005 depending on design choices.

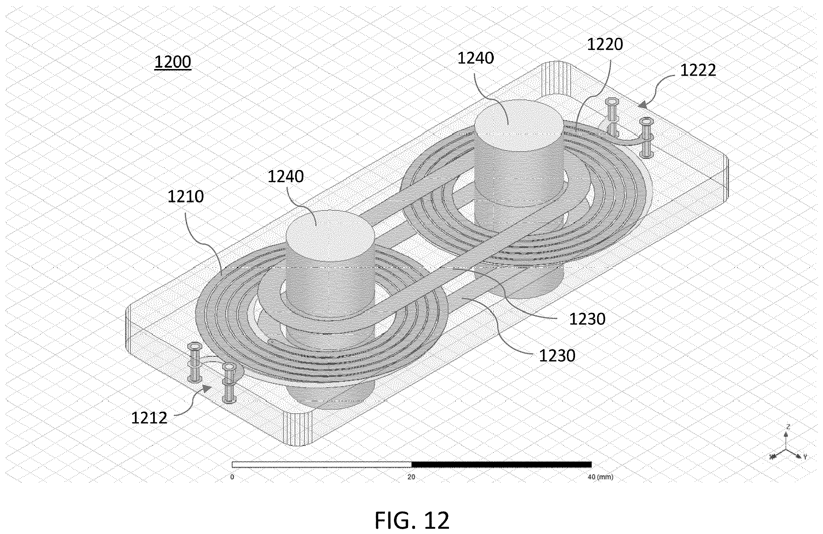

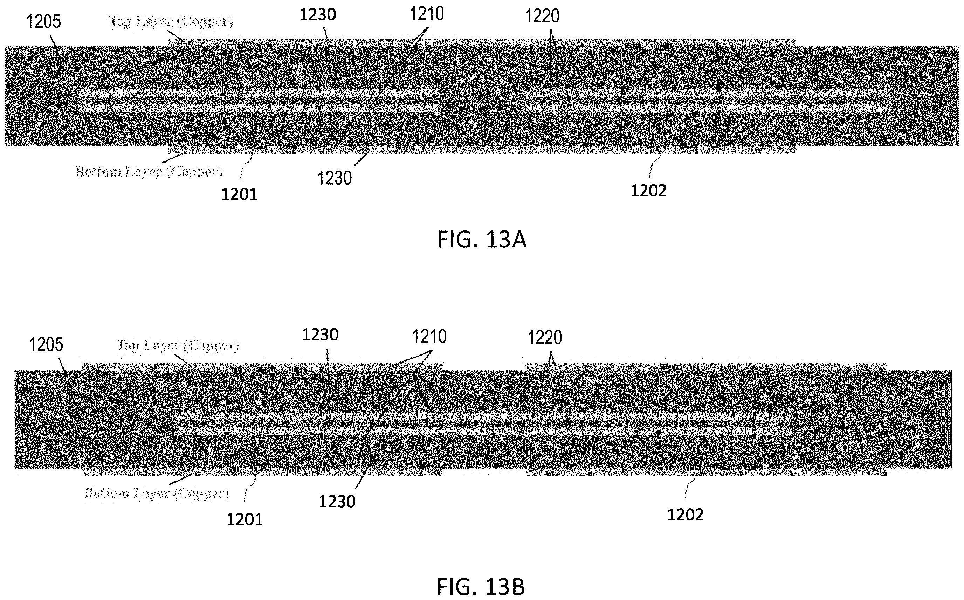

FIG. 12 illustrates an isolated gate driver transformer 1200 for a gate driver having increased coupling between primary and secondary windings 1210 and 1220, in accordance with another embodiment of the present disclosure. As shown in FIG. 12, two coupling coils 1230 are included to the isolation stage to further increase the inductive coupling coefficient between primary and the secondary windings 1210 and 1220. FIGs. 13A and 13B are sectional views of a PCB-based transformer of FIG. 12, demonstrating the placement of the coupling coil with respect to the primary and secondary windings. FIGs. 13A and 13B show two different placement options for coupling coils 1230. In operation, input voltage can be applied to primary winding 1210 via primary terminals 1212, while, output voltage can be harvested from secondary winding 1220 via secondary terminals 1222.

As shown in FIG. 13A, first and second coupling coils 1230 are respectively formed on top and bottom surfaces of PCB 1205, while primary and secondary windings 1210 and 1220 are disposed in the middle of PCB 1205. Primary winding 1210 is wound about a primary hole 1201 on PCB 1205, and a first magnetic core may be inserted therein. Secondary winding 1220 is wound about a secondary hole 1202 on PCB 1205, and a second magnetic core may be inserted therein. It is appreciated that the first and second magnetic cores may be a single piece or two isolated pieces as shown in FIG. 12. Coupling coils 1230 are respectively formed on top and bottom surfaces of PCB 1205 to form closed loops that surround both primary and secondary holes 1201 and 1202.

In contrast, as shown in FIG. 13B, first and second coupling coils 1230 are disposed in the middle of PCB 1205, while primary and secondary windings 1210 and 1220 are formed on top and bottom surfaces of PCB 1205. Coupling coils 1230 form closed loops that surround both primary and secondary holes 1201 and 1202, and are electrically insulated between each other. It is appreciated that variations to the quantity of coupling coils 1230 and the placement thereof can be carried out by one of ordinary skill in the art.

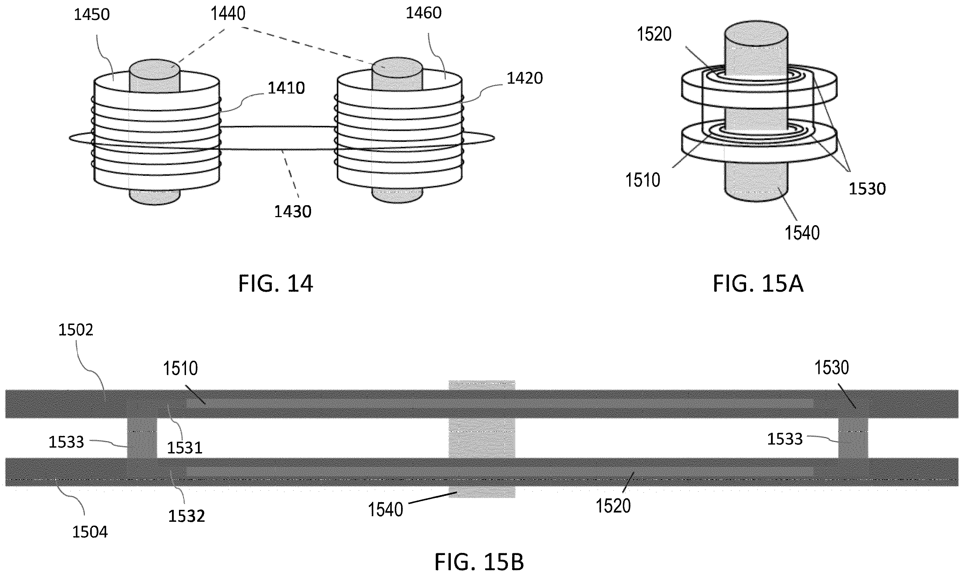

FIG. 14 illustrates a schematic diagram of a coupled transformer with primary and secondary windings and a coupling coil using copper wires and plastic (or any non-conductive material) bobbins and housing magnetic cores (made of, e.g., ferrite), in accordance with a further embodiment of the present disclosure. As shown in FIG. 14, primary winding 1410 is wound about first bobbin 1450, while secondary wining 1420 is would about second bobbin 1460. Each of first and second bobbins 1450 and 1460 includes a magnetic core 1440 inserted therein. Coupling coil 1430 forms a closed loop around both primary and secondary windings 1410 and 1420 with magnetic cores 1440 inserted in first and second bobbins 1450 and 1460, on which primary and secondary windings 1410 and 1420 are respectively wound.

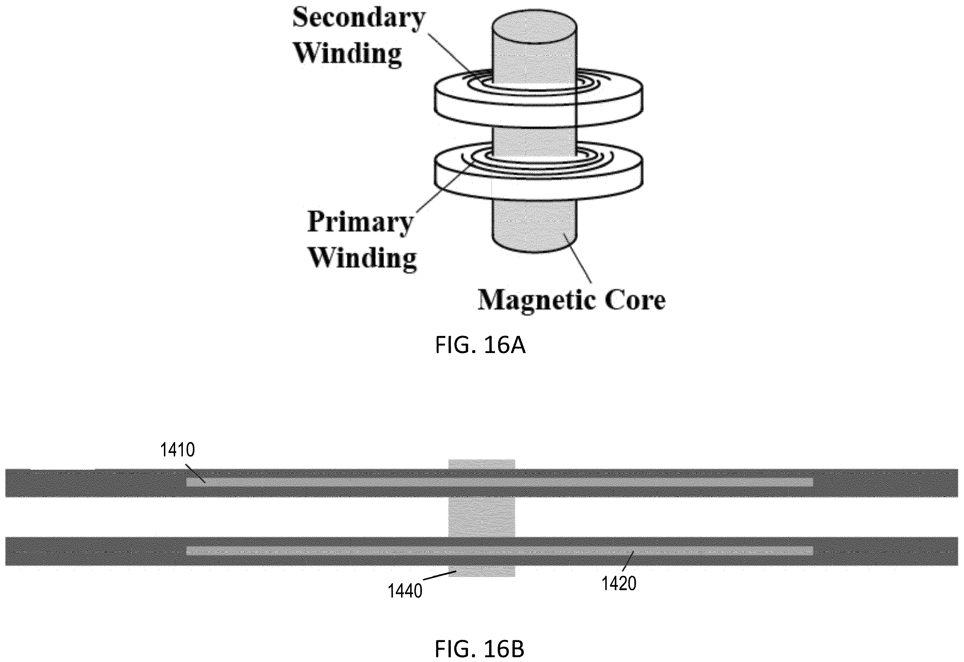

FIGs. 15A and 15B illustrate a variation of the coupled transformer of FIG. 14, with the windings and the coupling coil wound about a single magnetic core structure. As shown, primary and the secondary windings 1510 and 1520 are placed around the same magnetic core 1540. The structure may be realized using two different PCBs 1502 and 1504 with one placed on top of the other, with or without a gap between the PCBs. As shown in FIGs. 15A and 15B, coupling coil 1530 is realized using a conductive copper wire placed around the primary winding and the secondary winding to improve the magnetic coupling. In one embodiment, coupling coil 1530 includes a first semicircular wire 1531 proximate primary winding 1510, a second semicircular wire 1532 proximate secondary winding 1520, and two side wires 1533 connecting the first and second semicircular wires 1531 and 1532, thereby forming a closed loop. However, when a single ferrite core is used, coupling coil 1530 may not be required, and the required inductive coupling may be established by the ferrite core itself as shown in FIGs. 16A and 16B. Similar to the case in FIGs. 15A and 15B, the design in FIGs. 16A and 16B may be realized using PCB or with plastic (or any non-conductive material) based bobbin structure.

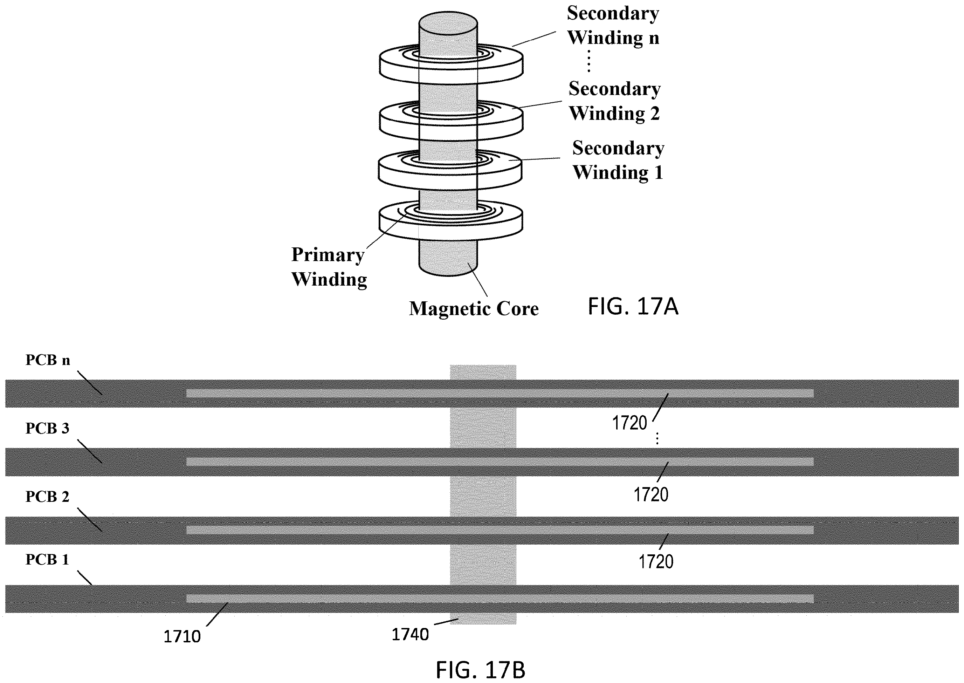

FIGs. 17A and 17B illustrate another variation of the coupled transformer of FIG. 14, with a primary winding and multiple secondary windings wound about a single magnetic core structure, without the coupling coil. As shown in FIGs. 17A and 17B, one PCB-based primary winding 1710 and multiple PCB-based secondary windings 1720 are coupled together through a magnetic core 1740. Each of PCB-based primary and second windings 1710 and 1720 has a central hole, such that magnetic core 1740 can be inserted therein. In one embodiment, PCB-based primary and second windings 1710 and 1720 are stacked on top of each other and separated by an equal distance. The multiple PCB-based secondary windings 1720 can be electrically connected in series to form a coil of more turns, or electrically separated to harvest electric power independently. In one embodiment, it is appreciated that any suitable quantity of PCB-based primary and second windings 1710 and 1720 can be used in accordance with design choices.

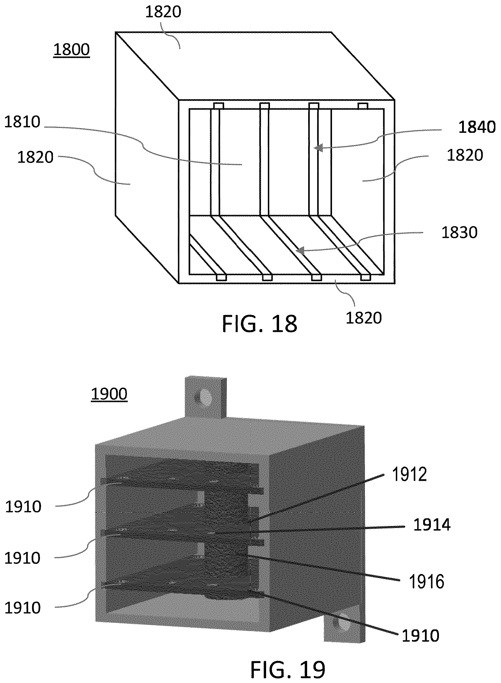

FIG. 18 illustrates a container 1800 for housing a PCB-based transformer, in accordance with an embodiment of the present disclosure. As shown in FIG. 18, container 1800 includes a bottom plate 1810 and four side plates 1820, so as to form a hollow rectangular cuboid having with an opening. Bottom plate 1810 and side plates 1820 may be manufactured as an integrated piece using a suitable additive manufacturing process, such as, 3D printing. A plurality of slots 1830 may be formed on opposing side plates 1820 to guide PCB-based windings into and out of container 1800. Additional slots 1840 may be formed on bottom plate 1810 to enhance the mechanical stability of the PCB-based windings when inserted in container 1800. Slots 1830 and 1840 may be spatially separated with each other by a predetermined distance to ensure that PCB-based windings are properly separated when inserted.

It is appreciated that, in an alternative embodiment, PCB-based primary and secondary windings can be inserted into or pulled out from container 1800 from different sides of container 1800. In this embodiment, a first opening is formed on a first side of container 1800 for insertion of the PCB-based primary windings, while a second opening is formed on a second side of container 1800 opposing the first side for insertion of the PCB-based secondary windings.

FIG. 19 illustrates a container 1900 in which a PCB-based transformer is housed, in accordance with an embodiment of the present disclosure. As shown in FIG. 19, in this embodiment, four PCB-based windings 1910 are inserted in container 1900. It is appreciated that some of PCB-based windings 1910 can serve as a primary winding, while the other ones of PCB-based windings 1910 can serve as a secondary winding. Each of PCB-based windings 1910 includes a central through hole 1912 for a magnetic core 1916 (having a suitable size that fits in container 1900) to penetrate therethrough, as shown in FIG. 17A, and two terminals 1914 for electrically coupling PCB-based windings 1910 to other circuits, e.g., a rectifier, a power source, a load, etc. In one embodiment, the entire structure can be potted using an encapsulant of relatively high dielectric strength. For example, PCB-based windings 1910 can be encapsulated by filling a resin material in container 1900. Terminals 1914 of all PCB windings 1910 can be arranged at the same side of container 1900. In one embodiment, each of terminals 1914 is electrically coupled to an electric wire, leading to the outside of the encapsulant (after terminals 1914 are buried by the encapsulant), so as to be exposed exterior to the encapsulant and allow easy electrical connection after the encapsulation process.

In addition, the present disclosure also provides a method for manufacturing a transformer, which includes the following steps. First, a container having an opening is provided. Then, a plurality of PCB-based windings are inserted in the container through the opening, and each PCB-based winding has one or more terminals such that all the terminals of the PCB-based windings are arranged at a same side of the container. Then, the transformer is encapsulated by filling an encapsulant in the container through the opening, with each PCB-based winding being connected to an electric wire leading exterior to the encapsulant. In an embodiment, prior to inserting the PCB-based windings in the container, the method further includes a step of inserting a magnetic core through a central through hole of each PCB-based winding.

As shown in FIG. 18 and FIG. 19, the method for manufacturing a transformer of one embodiment of the present disclosure includes:

providing container 1900 having an opening;

inserting a plurality of PCB-based windings 1910 in the container 1900 through the opening, wherein one or more of the PCB-based windings 1910 having one or more terminals 1914, such that the terminals 1914 of the PCB-based windings 1910 may be arranged at a same side of the container 1900; and

encapsulating the transformer by filling an encapsulant in the container 1900 through the opening, with each of the terminals 1914 of the PCB-based windings 1910 being connected to an electric wire leading exterior to the encapsulant. In one embodiment, the method further includes a step of inserting a magnetic core through a central through hole of the PCB-based winding before the step of inserting the PCB-based windings 1910 in the container 1900.

For the purposes of describing and defining the present disclosure, it is noted that terms of degree (e.g., "substantially," "slightly," "about," "comparable," etc.) may be utilized herein to represent the inherent degree of uncertainty that may be attributed to any quantitative comparison, value, measurement, or other representation. Such terms of degree may also be utilized herein to represent the degree by which a quantitative representation may vary from a stated reference (e.g., about 10% or less) without resulting in a change in the basic function of the subject matter at issue. Unless otherwise stated herein, any numerical value appearing in the present disclosure are deemed modified by a term of degree (e.g., "about"), thereby reflecting its intrinsic uncertainty.

## Claims

1. A power transformer (1000), **characterized by** comprising:

   a primary winding (1010) and a secondary winding (1020);
   a primary magnetic core (1040A) wound by the primary winding (1010);
   a secondary magnetic core (1040B) wound by the secondary winding (1020); and
   an electrically conductive coupling coil (1030) wound about the primary and secondary magnetic cores (1040A, 1040B).

2. The power transformer (1000 - FIG. 11A) of claim 1, wherein the primary winding (1010) comprises a first top coil and a first bottom coil electrically connected to the first top coil, and wherein the secondary winding (1020) comprises a second top coil and a bottom coil electrically connected to the second top coil.

3. The power transformer (1000) of claim 1 or 2, wherein the coupling coil (1030) is a closed loop disposed between the first and second top coils and the first and second bottom coils.

4. The power transformer (1000) of according to any one of the above claims, further comprising a printed circuit board (PCB) (1005) having a first hole (1001) and a second hole (1002), wherein the first top coil of the primary winding (1010) and the second top coil of the secondary winding (1020) are disposed on a top surface of the PCB (1005), wherein the first bottom coil of the primary winding (1010) and the second bottom coil of the secondary winding (1020) are disposed on a bottom surface of the PCB (1005), and wherein the coupling coil (1030) is embedded in the PCB (1005).

5. The power transformer (1000 - FIG. 11B) of claim 1, further comprising a printed circuit board (PCB) (1005) having a first hole (1001) and a second hole (1002), wherein the primary and secondary windings (1010, 1020) are embedded in the PCB (1005), and wherein the coupling coil (1030) is disposed on a surface of the PCB (1005).

6. The power transformer (1200) of claim 1, wherein the coupling coil (1230) comprises a first closed loop and a second closed loop.

7. The power transformer (1200 - FIG. 13A) of claim 6, wherein the primary and secondary windings (1210, 1220) are disposed between the first and second closed loops of the coupling coil (1230).

8. The power transformer (1200) of claim 6 or 7, further comprising a printed circuit board (PCB) (1205) having a first hole (1201) and a second hole (1202), wherein the primary and secondary windings (1210, 1220) are embedded in the PCB (1205), wherein the first closed loop of the coupling coil (1230) is disposed on a top surface of the PCB (1205), and wherein the second closed loop of the coupling coil (1230) is disposed on a bottom surface of the PCB (1205).

9. The power transformer according to any one of the above claims, wherein the primary magnetic core (1040A, 1240) is inserted in the first hole (1001, 1201), and the secondary magnetic core (1040B, 1240) is inserted in the second hole (1002, 1202).

10. A printed circuit board (PCB) (1005), **characterized by** comprising:

    a primary winding (1010) wound about a first hole (1001) of the PCB (1005);
    a secondary winding (1020) wound about a second hole (1002) of the PCB (1005); and
    a coupling coil (1030) forming a closed loop that surrounds the first and second holes (1001, 1002) of the PCB (1005).

11. The PCB (1005) of claim 10, wherein the coupling coil (1030) is embedded in the PCB (1005).

12. The PCB (1205) of claim 10 or 11, wherein the coupling coil (1230) comprises a plurality of conductive loops that are electrically insulated from each other.

13. The PCB (1005 - FIG. 11A) according to any one of claims 10 to 12, wherein the primary winding (1010) comprises a top layer on a top surface of the PCB (1005) and a bottom layer on a bottom surface of the PCB (1005), the top and bottom layers of the primary winding (1010) being electrically connected; and/or wherein the secondary winding (1020) comprises a top layer on a top surface of the PCB (1005) and a bottom layer on a bottom surface of the PCB (1005), the top and bottom layers of the secondary winding (1020) being electrically connected.

14. The PCB (1005 - FIG. 11B) of claim 10, wherein the primary and secondary windings (1010, 1020) are embedded in the PCB (1005).

15. The PCB (1005 - FIG. 11B) of claim 10, wherein the coupling coil (1030) is disposed on a top surface of the PCB (1005).

16. The PCB (1205 - FIG. 13A) of claim 10, wherein the coupling coil (1230) comprises a first coupling coil and a second coupling coil, wherein the first coupling coil is disposed on a top surface of the PCB (1205) and the second coupling coil is disposed on a bottom surface of the PCB (1205).

17. The PCB (1205) according to any of claims 10 to 16, further comprising at least one of primary terminals (1212) to receive an input voltage applied to the primary winding (1210) and secondary terminals (1222) to provide an output voltage induced by the secondary winding (1220).

18. A method for manufacturing the transformer according to any of the previous claims, **characterized by** comprising:

    providing a container (1900) having an opening;
    inserting a plurality of PCB-based windings (1910) in the container (1900) through the opening, each of the plurality of PCB-based windings (1910) having one or more terminals (1914), such that all the terminals (1914) of the plurality of PCB-based windings (1910) are arranged at a same side of the container (1900); and
    filling an encapsulant in the container (1900) through the opening, with each of the terminals (1914) of the plurality of PCB-based windings (1910) being connected to an electric wire leading exterior to the encapsulant.

19. The method of claim 18, further comprising:
    prior to inserting the plurality of PCB-based windings (1910) in the container (1900), inserting a magnetic core (1916) through a central through hole (1912) of each of the plurality of PCB-based windings (1910).

FIG. 1

FIG. 2

FIG. 3

FIG. 4

FIG. 5

FIG. 6

FIG. 7

FIG. 8

FIG. 9

FIG. 10

Top Layer (Copper)

Bottom Layer (Copper)

1005 1030 1010 1020 1002 1001

**FIG. 11A**

Top Layer (Copper)

1005 1030 1010 1020 1002 1001

**FIG. 11B**

FIG. 12

FIG. 13A

FIG. 13B

FIG. 14

FIG. 15A

FIG. 15B

EP 4 362 051 A1

Secondary Winding

Primary Winding

Magnetic Core

FIG. 16A

1410

1420

1440

FIG. 16B

FIG. 17A

FIG. 17B

EP 4 362 051 A1

FIG. 18

FIG. 19

EP 4 362 051 A1

Europäisches
Patentamt

European
Patent Office

Office européen
des brevets

**EUROPEAN SEARCH REPORT**

Application Number

EP 23 20 4030

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/332838 A1 (BLANKE JOERG [DE]) 19 November 2015 (2015-11-19) * 30-41 and 44-4; figures 1-4, 8-14 * | 1-19 | INV. H01F41/00 H01F27/28 H01F27/02 H01F27/38 |
| X | EP 2 144 070 A1 (LEM LIAISONS ELECTRON MEC [CH]) 13 January 2010 (2010-01-13) * 15, 24-32; figures 2-7 * | 1-4,6, 9-14, 17-19 | |
| X | EP 1 536 436 A1 (PREMO SA [ES]) 1 June 2005 (2005-06-01) * 18-23; figures 1-4 * | 18 | |

TECHNICAL FIELDS
SEARCHED       (IPC)

H01F

The present search report has been drawn up for all claims

| Place of search | Date of completion of the search | Examiner |
|---|---|---|
| Munich | 23 February 2024 | Brächer, Thomas |

EPO FORM 1503 03.82 (P04C01)

# EP 4 362 051 A1

## ANNEX TO THE EUROPEAN SEARCH REPORT
## ON EUROPEAN PATENT APPLICATION NO.

EP 23 20 4030

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2024

| Patent document cited in search report | Publication date | Patent family member(s) | Publication date |
|---|---|---|---|
| US 2015332838 A1 | 19-11-2015 | CN 104838458 A | 12-08-2015 |
| | | DE 102012111069 A1 | 22-05-2014 |
| | | EP 2920798 A1 | 23-09-2015 |
| | | US 2015332838 A1 | 19-11-2015 |
| | | WO 2014076067 A1 | 22-05-2014 |
| EP 2144070 A1 | 13-01-2010 | AT E550670 T1 | 15-04-2012 |
| | | CN 101625380 A | 13-01-2010 |
| | | EP 2144070 A1 | 13-01-2010 |
| | | JP 5733887 B2 | 10-06-2015 |
| | | JP 2010019843 A | 28-01-2010 |
| | | US 2010007358 A1 | 14-01-2010 |
| EP 1536436 A1 | 01-06-2005 | AU 2003242793 A1 | 19-01-2004 |
| | | EP 1536436 A1 | 01-06-2005 |
| | | ES 2197830 A1 | 01-01-2004 |
| | | WO 2004003947 A1 | 08-01-2004 |

EPO FORM P0459

For more details about this annex : see Official Journal of the European Patent Office, No. 12/82

## REFERENCES CITED IN THE DESCRIPTION

### Patent documents cited in the description

- US 10809326 B2, Wang R.

### Non-patent literature cited in the description

- **A. KADAVELUGU ; S. BHATTACHARYA.** Design considerations and development of gate driver for 15 kV SiC IGBT. *2014 IEEE Applied Power Electronics Conference and Exposition - APEC 2014,* 2014, 1494-1501
- **A. ANURAG ; S. ACHARYA ; Y. PRABOWO ; G. GOHIL ; S. BHATTACHARYA.** Design Considerations and Development of an Innovative Gate Driver for Medium-Voltage Power Devices With High dv/dt. *IEEE Transactions on Power Electronics,* June 2019, vol. 34 (6), 5256-5267
- **L. ZHANG et al.** Design Considerations for High-Voltage Insulated Gate Drive Power Supply for 10-kV SiC MOSFET Applied in Medium-Voltage Converter. *IEEE Transactions on Industrial Electronics,* July 2021, vol. 68 (7), 5712-5724
- **ROTHMUND et al.** Highly Compact Isolated Gate Driver With Ultrafast Overcurrent Protection for 10 kV SiC MOSFETs. *CPSS Transactions on Power Electronics and Applications,* December 2018, vol. 3 (4), 278-291
- **HU et al.** Current-Transformer Based Gate-Drive Power Supply with Reinforced Isolation. *2018 IEEE Energy Conversion Congress and Exposition (ECCE),* 2018
- **GOTTSCHLICH et al.** A galvanically isolated gate driver with low coupling capacitance for medium voltage SiC MOSFETs. *18th European Conference on Power Electronics and Applications (EPE'16 ECCE Europe),* 2016